(19) **Europäisches Patentamt European Patent Office Office européen des brevets**

(11) **EP 3 238 232 B1**

(12) **FASCICULE DE BREVET EUROPEEN**

(45) Date de publication et mention de la délivrance du brevet:
**15.12.2021 Bulletin 2021/50**

(21) Numéro de dépôt: **15820157.4**

(22) Date de dépôt: **22.12.2015**

(51) Int Cl.:
*H01L 21/308* (2006.01)  *H01L 21/306* (2006.01)
*H01L 21/3065* (2006.01)  *H01L 21/311* (2006.01)
*B81C 1/00* (2006.01)  *H01L 31/0236* (2006.01)
*H01L 33/20* (2010.01)  *G03F 7/00* (2006.01)

(86) Numéro de dépôt international:
**PCT/EP2015/081062**

(87) Numéro de publication internationale:
**WO 2016/102609 (30.06.2016 Gazette 2016/26)**

(54) **PROCÉDÉ D'OBTENTION DE MOTIFS DANS UNE COUCHE**

VERFAHREN ZUR ERZEUGUNG VON MUSTERN IN EINER SCHICHT

METHOD FOR OBTAINING PATTERNS IN A LAYER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.12.2014 FR 1463145**

(43) Date de publication de la demande:
**01.11.2017 Bulletin 2017/44**

(73) Titulaire: **Commissariat à l'Énergie Atomique et aux Énergies Alternatives 75015 Paris (FR)**

(72) Inventeurs:
• **LANDIS, Stéphan**
  **38210 Tullins (FR)**
• **POSSEME, Nicolas**
  **38360 Sassenage (FR)**
• **NOURI, Lamia**
  **38100 Grenoble (FR)**

(74) Mandataire: **Hautier, Nicolas**
  **Cabinet Hautier**
  **20, rue de la Liberté**
  **06000 Nice (FR)**

(56) Documents cités:
| EP-A2- 2 264 772 | FR-A1- 2 977 071 |
| FR-A1- 2 995 134 | US-A1- 2011 097 827 |
| US-A1- 2013 284 697 | US-A1- 2014 175 051 |

• ZHANNA SMAGINA ET AL: "Nucleation and epitaxial growth of Ge nanoislands on Si surface prepatterned by ion irradiation", PHYSICA STATUS SOLIDI. A: APPLICATIONS AND MATERIALS SCIENCE, vol. 210, no. 8, 5 juillet 2013 (2013-07-05), pages 1522-1524, XP055219937, DE ISSN: 1862-6300, DOI: 10.1002/pssa.201200906
• WEI ZHOU ET AL: "Fabrication of bridged-grain polycrystalline silicon thin film transistors by nanoimprint lithography", THIN SOLID FILMS, vol. 534, 1 mai 2013 (2013-05-01), pages 636-639, XP055219967, CH ISSN: 0040-6090, DOI: 10.1016/j.tsf.2013.02.114
• SCHMIDT CHRISTOPH ET AL: "Artificial sub-[mu]m magnetic patterning by He+ion bombardment through a mask fabricated by Ultraviolet Nanoimprint Lithography (UV-", NUCLEAR INSTRUMENTS & METHODS IN PHYSICS RESEARCH. SECTION B: BEAM INTERACTIONS WITH MATERIALS AND ATOMS, vol. 322, 29 janvier 2014 (2014-01-29), pages 59-62, XP028608291, ISSN: 0168-583X, DOI: 10.1016/J.NIMB.2014.01.005

## Description

DOMAINE TECHNIQUE DE L'INVENTION

L'invention concerne en général la réalisation de structures bidimensionnelles (2D) ou tridimensionnelles (3D) c'est-à-dire la formation de structures ayant un profil présentant au moins deux niveaux discrets de hauteurs ou qui présentent un profil analogique avec une variation continue des tangentes de la forme du profil.

Elle trouve pour application particulièrement avantageuse le domaine de la lithographie par impression nanométrique où l'on procède tout d'abord à la reproduction des motifs dans un matériau temporaire afin que ces derniers puissent être ensuite transférer fidèlement, par l'intermédiaire du matériau temporaire, dans un substrat ou une couche mince.

L'invention trouve pour application avantageuse la réalisation de structures dans lesquelles les motifs formés dans la couche sous-jacente sont enterrés ou encapsulés.

ÉTAT DE LA TECHNIQUE

Les techniques de transfert de reliefs par impression encore appelées nano-impression de l'anglais « nanoimprint », appartiennent à une technologie générique qui regroupe une multitude d'approches très différentes mais qui possèdent toutes néanmoins un point commun : l'utilisation d'un tampon ou moule (de l'anglais « stamp » ou « mold ») permettant de transférer sur une surface ou dans l'épaisseur d'un matériau un motif 2D ou 3D. Toutes ces approches d'une même technologie ont donc en commun qu'un contact intime entre le support originel de l'information (le moule) et celui recevant cette information (le substrat) soit réalisé au cours de cette opération.

Dans tous les cas, les technologies de nano-impression se différencient des procédés de lithographie conventionnels (photolithographie classique à l'aide de masques, lithographie électronique, lithographie par rayons X ou encore par ultra-violet ou UV) par le mécanisme fondamental qui va créer les motifs. Pour toutes les techniques classiques ci-dessus, les motifs sont créés par le biais d'un contraste physico-chimique. La résine exposée à la lumière ou aux rayonnements, si elle est de tonalité positive, pourra être sélectivement développée. C'est l'inverse qui se produit si la résine est de tonalité négative. Pour la nano-impression le contraste est topographique : c'est le déplacement de matière et l'écoulement de la résine dans les cavités du moule qui vont permettre la création de motifs spécifiques.

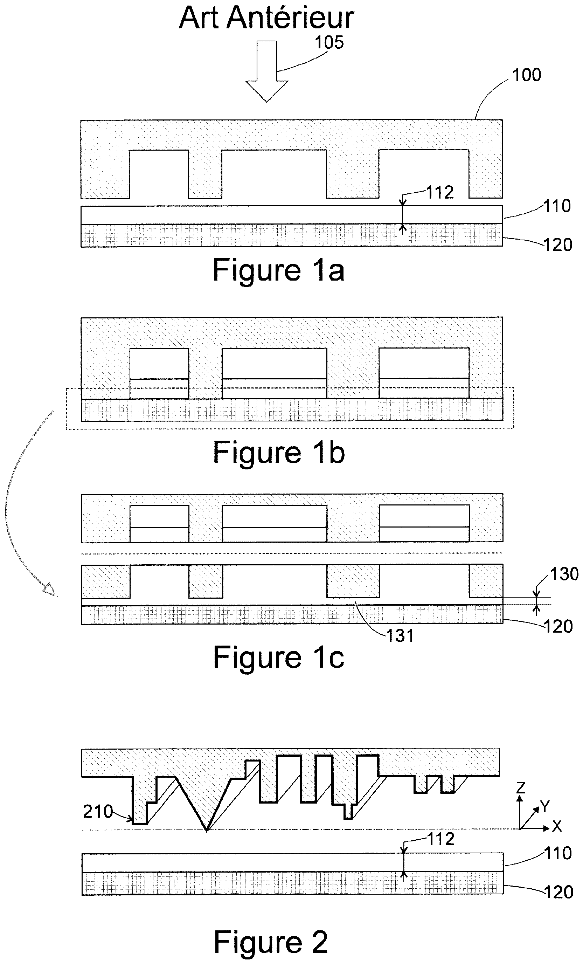

Les **figures 1a à 1c** illustrent une opération d'impression au cours de laquelle un moule 100 pénètre dans une couche de résine 110 surmontant un substrat 120 afin de former dans la résine 110 des motifs.

Une fois les motifs imprimés dans la résine 110, ils peuvent être transférés par gravure dans le substrat 120. Ensuite les motifs formés dans le substrat 120 peuvent être encapsulés en déposant une couche d'encapsulation recouvrant la totalité des motifs. Le matériau de la couche d'encapsulation peut être différent de celui des motifs formés dans le substrat 120. Dans ce cas la couche d'encapsulation peut être au contact des motifs.

Ces motifs transférés dans le substrat 120 sont ainsi enterrés sous une couche d'encapsulation.

Les solutions connues ne permettent pas d'obtenir de manière simple et reproductible des motifs enterrés présentant des formes relativement complexes et dont les dimensions sont contrôlées avec précision.

La figure 1b illustre un cas idéal dans lequel les reliefs du moule 100 viennent en contact avec le substrat 120 en supprimant toute présence de résine 110 entre le sommet des reliefs du moule 110 et le substrat 120.

En pratique, les conditions de mise en oeuvre sont telles que dans la majorité des cas on applique sur le moule 100 une pression 105 inférieure à 100 bars, pendant un temps inférieur à une heure et à une température qui ne dépasse pas 100°C. Dans ces conditions on constate alors qu'avec les matériaux utilisés comme résine qui sont typiquement des monomères, oligomères ou polymères, les propriétés de ceux-ci sont telles qu'elles ne permettent pas aux reliefs du moule 100 d'atteindre l'interface substrat 120 résine 110 pendant le pressage.

Par conséquent, comme illustré sur la figure 1c, une couche résiduelle 131 de résine reste présente entre la surface du substrat 120 et les reliefs du moule 100. L'épaisseur 130 de cette couche résiduelle 131 dépend des conditions de pressage mais aussi de la géométrie du moule 100 et du volume initial de résine 110 disponible.

Le problème s'est donc rapidement posé de savoir si une approche prédictive du procédé de pressage pouvait être proposée et en particulier si il était possible de prévoir l'épaisseur résiduelle 130 connaissant la géométrie du moule 100 ainsi que l'épaisseur initiale 112 de polymère imprimé. Ceci est illustré par la **figure 2** où l'on définit la surface d'un moule à l'aide d'une fonction $p(x, y)$ décrivant son profil 210.

En considérant que le matériau à imprimer puisse s'écouler sur des distances identiques à celle de l'échantillon, il est alors possible d'établir un critère simple pour savoir si le moule peut-être complètement rempli ou non. La figure 2 représente un profil arbitraire d'une structure 3D à imprimer avec l'épaisseur initiale 112 de matériau à mettre en forme, qui est noté $hi$ ci-après, S étant la surface du substrat et du moule et $p(x,y)$ la fonction mathématique décrivant le profil 210 du moule. Le calcul du ratio $(f)$ entre le volume à remplir dans le moule $(Vm)$ et le volume de matière incompressible disponible $(Vi)$ permet d'identifier trois configurations.

$$f = \frac{Vm}{Vi} = \frac{\iint_S p(x,y)dxdy}{h_i S} \begin{cases} < 1 \\ = 1 \\ > 1 \end{cases}$$

Pour un ratio *f* inférieur à 1, le remplissage total du moule est possible puisque la matière est présente en excès. Dans ce cas de figure l'épaisseur résiduelle théorique $(h_r)$ pourrait être calculée et serait alors donnée par la relation suivante :

$$h_r = h_i - \frac{\iint_S p(x,y)dxdy}{S}$$

Un ratio égal à 1 implique que le volume de matière disponible est équivalent au volume à remplir, impliquant donc une épaisseur résiduelle théorique égale à zéro. Enfin, pour un ratio inférieur à 1, les cavités du moule ne pourront être complètement remplies.

On notera que cette relation ne fait apparaître ni les conditions de pressage (température, pression, temps d'impression) ni les propriétés du matériau (viscosité, énergie de surface) et que par conséquent elle ne peut être considérée pour décrire la dynamique du processus. Elle ne peut que refléter un état final idéal du procédé. Il faut également souligner que cette approche est très simplifiée et n'est que très peu applicable telle quelle de par la complexité de l'interaction fluide (résine) avec la structure (moule) pendant l'étape de pressage. Elle peut être vérifiée néanmoins pour l'impression de motifs de densité constante présents sur des surfaces supérieures à plusieurs millimètres carrés ($mm^2$). Dès qu'une modification de la densité des motifs à imprimer intervient, et ce même à courte distance, cette approche n'est plus valide et des déformations de moule pendant le pressage doivent être considérées. Cela rend l'approche prédictive quasiment impossible, voire très difficile, même avec des outils numériques avancés.

La présence de la couche résiduelle 131 de résine est donc un problème spécifique à la technique de nano-impression. La présence d'une couche résiduelle et son épaisseur engendrent deux problématiques totalement nouvelles pour la mise en oeuvre de la nano-impression :

- le problème se pose, après pressage, d'avoir à supprimer cette couche résiduelle 131 de résine tout en conservant la forme et les dimensions des motifs imprimés afin d'obtenir un masque de résine présentant les mêmes caractéristiques que celles qui seraient obtenues avec les techniques standard de lithographie ;
- un autre problème est d'assurer l'uniformité de son épaisseur afin que les étapes technologiques qui suivent puissent être appliquées sans difficulté.

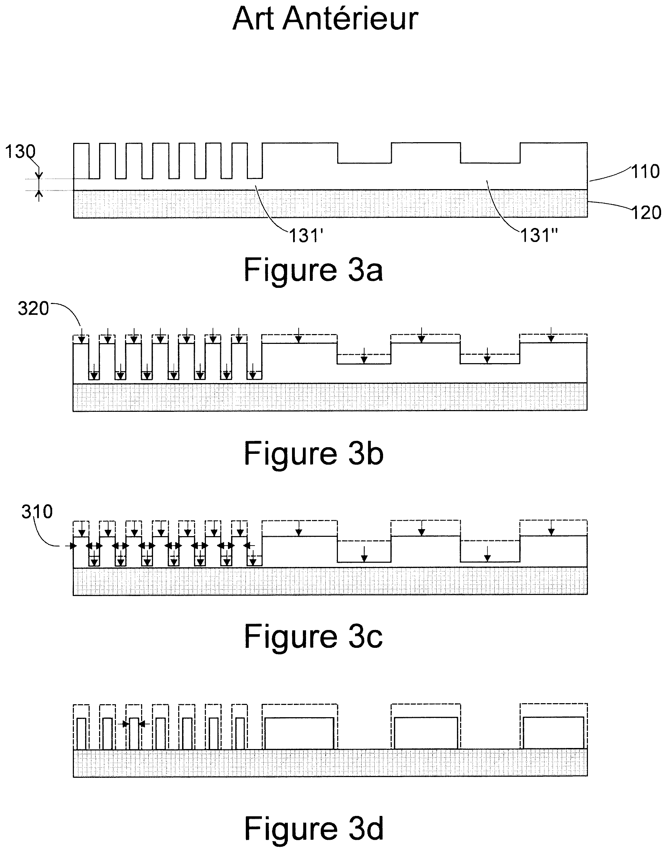

Le premier point ne constitue pas une barrière technologique lorsque le matériau mis en forme sera par la suite un élément fonctionnel du composant en cours de fabrication. Néanmoins, dans une grande majorité de situations, la résine imprimée ne sert que de masque pour transférer ensuite l'information topographique dans un matériau sous-jacent à l'aide d'un procédé de gravure. Dans ces cas-là il est alors nécessaire de disposer d'un procédé de gravure le plus anisotrope possible (selon la direction Z du repère illustré en figure 2), c'est à dire ayant une vitesse de gravure parallèle au plan du substrat (plan X,Y) la plus faible possible voire, idéalement, qui serait nulle. Dans le cas contraire, toute étape de gravure de l'épaisseur résiduelle engendre des modifications de dimensions horizontales des motifs imprimés et par conséquent une perte d'information généralement inacceptable lors de l'étape de lithographie correspondante comme illustré sur les **figures 3a à 3d** décrites ci-dessous. La mise au point de procédés de gravure les plus anisotropes possibles entre deux matériaux est une contrainte très courante dans le domaine des micro et nanotechnologies. Leur mise en oeuvre peut être très compliquée pour des dimensions très petites, inférieures à 30 nanomètres (nm), et pour des profils 3D.

Les figures 3a à 3d illustrent les problèmes exposés ci-dessus qui résultent de la nécessité d'avoir à enlever après impression la couche résiduelle 131 de résine 110 à l'aide d'un procédé qui doit pouvoir aussi tenir compte de la non uniformité potentielle de cette couche. Ce n'est qu'après enlèvement de la couche résiduelle 131 que l'on pourra ensuite procéder à la gravure du substrat sous-jacent 120. Les figures 3a à 3d mettent en évidence l'impact des vitesses de gravure horizontale 310 et verticale 320 sur la conservation des dimensions originales.

On remarquera ici que l'uniformité de l'épaisseur résiduelle 130 est alors un élément important pour faciliter son retrait et permettre l'utilisation du masque de résine comme masque de gravure. Comme mentionné précédemment, cette valeur va dépendre en général de la géométrie du moule incluant des paramètres géométriques tels que les tailles des différents motifs, leurs densités, les ruptures de symétrie de la trame des motifs. La valeur de l'épaisseur résiduelle va aussi dépendre, comme on l'a vu sur les figures 1 et 2, de l'épaisseur initiale 112 à imprimer ainsi que des conditions d'impression : température, force appliquée, temps d'impression. Sur les figures 3a, on a illustré avec les références 131' des zones où l'épaisseur résiduelle est plus faible que sous d'autres motifs 131".

Les documents suivants décrivent des procédés de réalisation de motifs utilisant une technique de nano-impression:

- ZHANNA SMAGINA ET AL: "Nucleation and epitaxial growth of Ge nanoislands on Si surface prepatterned by ion irradiation", Physica Status Solidi. A: Applications and Materials Science, vol. 210, no. 8, 2013, pages 1522-1524;

- WEI ZHOU ET AL: "Fabrication of bridged-grain polycrystalline silicon thin film transistors by nanoimprint lithography", Thin Solid Films, Thin Solid Films, vol. 534, 2013, pages 636-639;
- SCHMIDT CHRISTOPH ET AL: "Artificial sub-$\mu$m magnetic patterning by He+ ion bombardment through a mask fabricated by Ultraviolet NanoImprint Lithography (UV-NIL)", Nuclear Instruments & Methods in Physics Research. Section B: Beam Interactions with Materials and Atoms, vol. 322, 2014, pages 59-62;
- US 2014/175051 A1;
- FR 2 977 071 A1;
- US 2013/284697 A1;
- US 2011/097827 A1.

Un objet de la présente invention est donc de proposer une solution qui limite, au moins en partie, les difficultés décrites ci-dessus et qui permette d'obtenir de manière fiable et simple des motifs protégés ou encapsulés dont le dimensions sont contrôlées avec précision.

Les autres objets, caractéristiques et avantages de la présente invention apparaîtront à l'examen de la description suivante et des dessins d'accompagnement. Il est entendu que d'autres avantages peuvent être incorporés.

RÉSUMÉ DE L'INVENTION

Pour atteindre cet objectif, la présente invention concerne un procédé de réalisation de motifs ultérieurs dans une couche sous-jacente, le procédé étant tel que défini dans la revendication indépendante 1. Les différentes caractéristiques optionnelles sont définies dans les revendications dépendantes.

Ainsi, l'invention permet d'obtenir dans la couche sous-jacente des motifs enterrés dont les dimensions sont contrôlées de manière particulièrement précise. Les zones modifiées lors de l'implantation peuvent être conservées ou au contraire être retirées.

On obtient ainsi une couche sous-jacente présentant des propriétés, par exemple optiques modifiées du fait de la présence de cette implantation de motifs enterrés.

Par ailleurs, les motifs enterrés obtenus sont protégés par la zone continue qui s'étend transversalement depuis la face supérieure de la couche sousjacente et jusqu'aux motifs, et qui s'étend sur toute la surface de la couche sous-jacente.

Cette solution pour encapsuler des motifs est par ailleurs plus rapide mettre en oeuvre, moins complexe et moins couteuse qu'une solution consistant à déposer sur des zones déjà implantées ou déjà gravées une couche d'encapsulation.

Par ailleurs, l'invention permet d'obtenir dans la couche sous-jacente des motifs possiblement complexes et très précis en supprimant les inconvénients habituellement induits par la couche résiduelle.

La gravure de cette couche résiduelle qui est inévitablement obtenue en fin d'impression, entraine, avec les procédés connus, des modifications non souhaitées et difficilement prévisibles au niveau de la forme et/ou des dimensions des motifs finaux.

L'invention, en se basant sur une étape de modification de la couche sous-jacente à travers la couche imprimable, permet de transférer dans cette couche sous-jacente les motifs imprimés ou des motifs fonction des motifs imprimés, sans avoir à retirer la couche résiduelle. Les motifs obtenus ne sont donc pas déformés par une étape de retrait de la couche résiduelle.

Dans le cadre de la présente invention, l'adjectif « sous-jacente » dans l'expression « couche sousjacente » est relatif à la direction et le sens de l'implantation des ions uniquement. La couche sous-jacente est positionnée en aval de la couche imprimable par rapport au sens d'implantation des ions. Sur les figures qui suivent, la direction et le sens d'implantation des ions étant verticale et vers le bas, la couche sous-jacente est positionnée plus bas que la couche imprimable. Si l'implantation est dirigée verticalement et vers le haut, la couche sous-jacente, toujours positionnée en aval de la couche imprimable par rapport au sens d'implantation des ions, serait alors positionnée sur les figures plus haut que la couche imprimable.

- Dans le cadre de l'invention, l'étape de réalisation de motifs antérieurs est réalisée de manière à ce que pour chacun des motifs l'épaisseur résiduelle de la couche imprimable soit inférieure à la profondeur minimale d'implantation des ions implantés lors de ladite implantation, la profondeur minimale étant prise selon la direction d'implantation et à partir de la surface de la couche imprimable. Typiquement cette épaisseur minimale correspond à une épaisseur résiduelle laissée en place par l'étape de nanoimpression.

L'épaisseur minimale de la couche imprimable correspond à la couche résiduelle. En réglant l'épaisseur de la couche résiduelle, on s'assure ainsi que les ions peuvent être implantés sans modifier une zone de la couche sous-jacente qui s'étend depuis la face supérieure de cette couche. Cette zone non modifiée est continue selon un plan parallèle au plan principal dans lequel s'étend la couche sous-jacente et s'étend sur toute la surface de la couche sous-jacente.

- Avantageusement la zone non modifiée continue située entre les zones modifiées et une face de la couche sous-jacente par laquelle les ions pénètrent lors de l'implantation présente une épaisseur supérieure ou égale à 10nm, de préférence supérieure ou égale à 20nm, de préférence supérieure ou égale à 30nm et de préférence supérieure ou égale à 40nm.
- Selon un mode de réalisation, les matériaux de la couche imprimable et de la couche sous-jacente ainsi que les paramètres de l'implantation, notamment la nature des ions, sont choisis de manières à ce que les matériaux de la couche imprimable et de la couche sous-jacente présentent des capacités de pénétration des ions identiques.

Ainsi, à conditions d'implantation égales, notamment pour une même énergie des ions, les ions pénètrent de la même manière dans une couche faite du matériau de la couche imprimable et dans une couche faite du matériau de la couche sous-jacente.

Ainsi, lorsque ces couches sont empilées, l'implantation à partir de la couche imprimable permet de reproduire les motifs de cette dernière dans la couche sous-jacente. On peut qualifier l'implantation « de conforme », le profil défini par la frontière entre les zones implantées et les zones non implantées reproduisant le profil défini par les motifs imprimés dans la couche imprimable.

Cette implantation d'ions permet ainsi d'effectuer un transfert de motifs depuis la couche imprimable vers la couche sous-jacente, les motifs transférés étant formés par le matériau modifié de la couche sous-jacente.

- Selon un mode de réalisation alternatif, les matériaux de la couche imprimable et de la couche sous-jacente ainsi que les paramètres de l'implantation sont choisis de manière à ce que les matériaux de la couche imprimable et de la couche sous-jacente présentent des capacités différentes de pénétration des ions. Ainsi l'implantation à partir de la couche imprimable permet de générer dans la couche sous-jacente des motifs non identiques à ceux de la couche imprimable. Typiquement les motifs de la couche sous-jacente sont des homothéties de ceux de la couche imprimable.

La profondeur minimale d'implantation est supérieure à l'épaisseur de la couche résiduelle plus l'épaisseur de l'éventuelle couche tampon. Ainsi, au niveau des zones modifiées les ions ne sont pas implantés en continu depuis la surface de la couche à graver.

BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

La FIGURE 1, composée des figures 1a à 1c, décrit les étapes d'une opération de nano-impression selon l'art antérieur.
La FIGURE 2 montre la définition d'un moule à l'aide d'une fonction décrivant son profil.

La FIGURE 3, composée des figures 3a à 3d, illustre les problèmes posés par l'enlèvement de la couche résiduelle de résine après une opération d'impression.

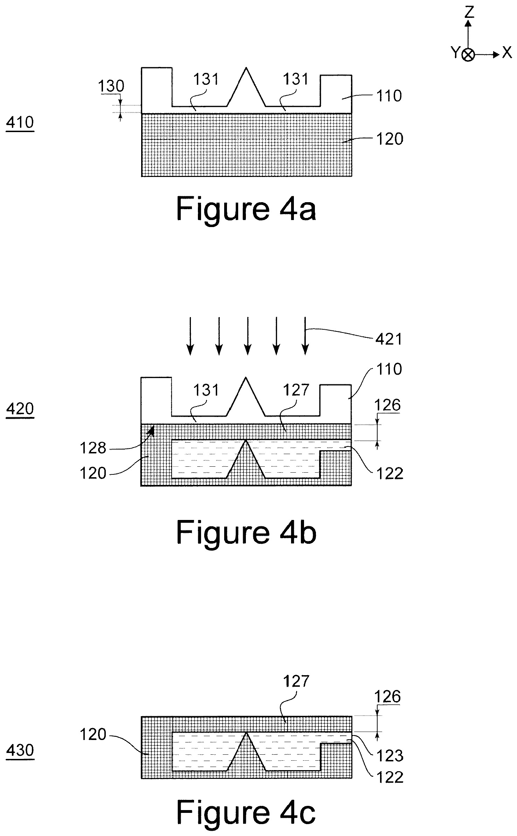

La FIGURE 4, composée des figures 4a à 4c, illustre un procédé selon un mode de réalisation de l'invention dans laquelle on réalise des structures enterrées dans un substrat.

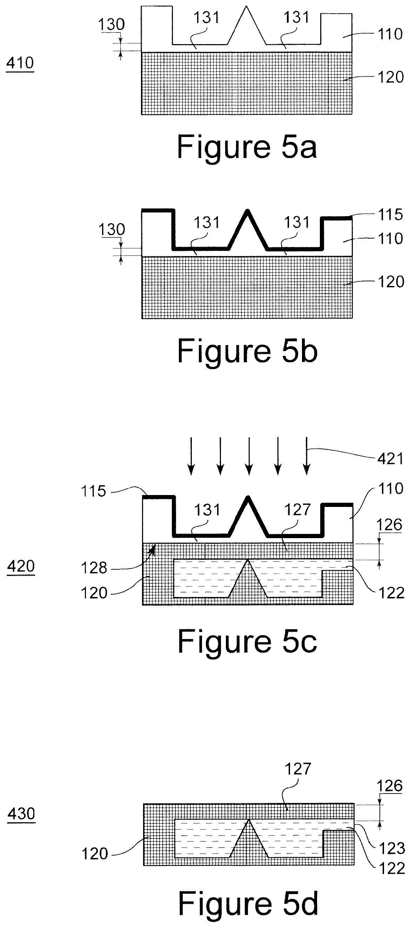

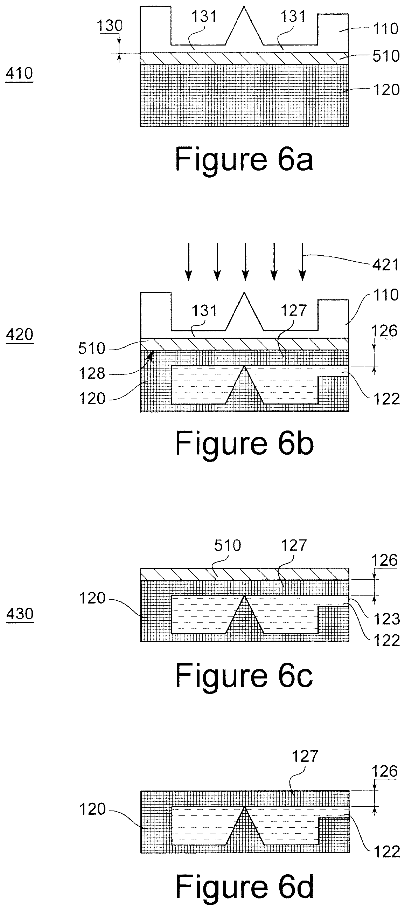

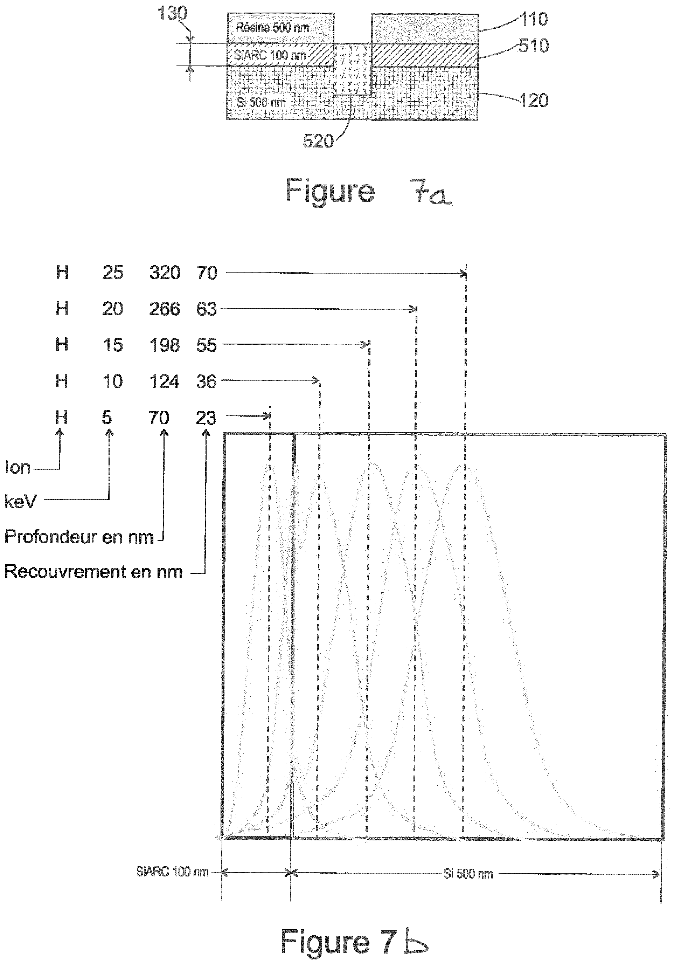

La FIGURE 5, composée des figures 5a à 5d illustre une variante du procédé de la figure 4, dans laquelle on utilise une couche de protection sur la couche imprimable. La FIGURE 6, composée des figures 6a à 6d, décrit brièvement les étapes principales d'un procédé selon un mode de réalisation de l'invention particulièrement bien adapté à la gravure de SiOCH. La FIGURE 7 composée des figures 7a et 7b, illustre en figure 7a un empilement comprenant une couche tampon et illustre en figure 7b le résultat de l'implantation en faisant varier certains paramètres d'implantation.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches, films reliefs et motifs ne sont pas représentatives de la réalité.

DESCRIPTION DÉTAILLÉE DE L'INVENTION

- Dans le cadre de l'invention, les paramètres de l'implantation comprennent notamment une direction d'implantation. La direction d'implantation (direction Z du repère illustré en figure 4a) est perpendiculaire au plan principal dans lequel s'étend la couche sous-jacente. Il s'agit typiquement du plan X,Y du repère illustré en figure 4a.
- Selon un mode de réalisation, les paramètres de l'implantation sont choisis de manière à ce que les motifs ultérieurs présentent une géométrie identique à celle des motifs antérieurs.
- Selon un mode de réalisation, les matériaux des couches imprimables et de la couche sous-jacente, ainsi que la nature des ions sont choisis de manière à ce que la pénétration des ions dans l'un des matériaux pris parmi le matériau de la couche imprimable et le matériau de la couche sous-jacente soit supérieure à la pénétration des ions dans l'autre des matériaux pris parmi le matériau de la couche imprimable et le matériau de la couche sous-jacente.
- Selon un mode de réalisation, le procédé comprend, après l'étape de modification, au moins une étape de retrait des zones modifiées effectuée de manière sélective par rapport aux zones non modifiées, de manière à laisser en place les zones non modifiées.

- Avantageusement, l'étape de retrait comprend une étape de gravure des zones modifiées sélectivement aux zones non modifiées, l'étape de gravure étant une gravure par voie humide ou par voie sèche.
- Selon un mode de réalisation, après l'étape de modification, on conserve au moins une partie et de préférence toutes les zones modifiées et les zone non modifiées.
- Dans le cadre de l'invention, ladite zone non modifiée s'étend sur toute la surface de la couche à graver.
- Avantageusement l'implantation est effectuée pleine plaque.
- Dans le cadre de l'invention, l'implantation d'ions est réalisée de manière à ce que la couche sous-jacente présente une zone non modifiée continue située entre les zones modifiées et une face de la couche sous-jacente par laquelle les ions pénètrent lors de l'implantation. Ainsi, la couche sous-jacente présente une épaisseur non modifiée séparant les zones modifiées de l'extérieur de la couche sous-jacente. Cette épaisseur permet ainsi d'encapsuler et de protéger les zones modifiées. Ces zones modifiées forment ainsi des structures enterrées. Elles peuvent présenter des propriétés électriques, optiques, magnétiques, thermiques, mécaniques particulières et notamment différentes de celle des zones non modifiées et ceci que les zones modifiées soient conservées ou gravées.
- Dans le cas où les zones modifiées sont conservées, au moins l'une de leurs propriétés optiques, électriques, magnétiques, thermiques ou mécaniques est différente de celle des motifs formés par une zone non modifiée.
- Dans le cas où les zones modifiées sont retirées, les motifs formés par les zones non modifiées sont alors entourés, au moins partiellement de vide ou de gaz. Le gaz peut être de l'air ambiant. Il peut aussi s'agir d'un gaz injecté dans la cavité formée par le retrait des zones modifiées. En effet, du gaz peut être injecté par l'entrée ayant servi à la gravure des zones modifiées. Un bouchon est ensuite formé pour boucher l'entrée afin de conserver les gaz dans la structure. Les motifs formés par les zones non modifiées présentent alors au moins l'une de leurs propriétés optiques, électriques, magnétiques, thermiques ou mécaniques différente de celle du gaz qui les environne.
- Selon un mode de réalisation, ladite gravure des zones modifiées forme au moins une cavité. On introduit au moins un gaz dans ladite cavité. Selon un mode de réalisation, on forme ensuite un bouchon pour obturer une ouverture par laquelle ledit au moins un gaz a été introduit dans la cavité. L'introduction de ce gaz permet de régler les paramètres optiques, électriques, mécanique de la structure. Par ailleurs, la présence de la couche continue permet de confiner de manière fiable et simple ce gaz à l'intérieur de la structure.

- De préférence, l'implantation est réalisée au moyen d'un implanteur configuré de manière à implanter des ions qu'à partir d'une profondeur non nulle de la couche sous-jacente. Ainsi l'implanteur n'implante pas les ions de manière continue depuis la surface de la couche sous-jacente à travers laquelle les ions sont implantés.
- Selon un mode de réalisation, le procédé comprend, entre l'étape de réalisation des motifs antérieurs et l'étape d'implantation, une étape de dépôt d'une couche de protection recouvrant les motifs antérieurs. Avantageusement, cette couche protège les motifs antérieurs lors de l'implantation. Ces derniers conservent ainsi, lors de l'implantation, les formes et dimensions conférées par l'impression.
- De préférence, la couche de protection est une couche de carbone déposée à partir d'un plasma.
- Selon un mode de réalisation alternatif, la couche sous-jacente est directement au contact de la couche imprimable.

Avantageusement, les paramètres d'implantation, en particulier l'énergie communiquée aux ions, la durée et la dose d'implantation sont prévus de sorte que les zones implantées puissent être gravées sélectivement par rapport aux zones non-implantées. De préférence, ces paramètres d'implantation permettent de faire passer la matière depuis un état cristallin à un état amorphe.

De préférence, l'implantation d'espèces concerne tous les éléments que l'on peut implanter dans le matériau à graver, sans provoquer de dislocation de sa structure atomique telle qu'elle entraînerait une pulvérisation de la matière implantée, sont susceptibles de convenir.

Par exemple, les ions implantés sont pris parmi l'hydrogène ($H2$), l'hélium (He), l'argon (Ar) ou l'azote ($N2$). Une seule ou plusieurs de ces espèces peuvent être implantées.

Selon un mode de réalisation, l'implantation est réalisée de manière anisotrope, selon au moins une direction d'implantation sensiblement perpendiculaire au plan dans lequel s'étend la couche à graver ou un substrat sur lequel est disposée la couche à graver. Sur les figures, la direction privilégiée d'implantation est la direction Z.

Dans le cadre de la présente invention on pourra utiliser les méthodes connues de l'homme du métier et logiciels (SRIM, TRIM, CTRIM...) qui permettent de simuler en fonction des conditions d'implantations l'implantation résultante et notamment la profondeur d'implantation. Parmi les paramètres de l'implantation figurent : la nature de la ou des espèces implantées, le matériau de la couche sous-jacente, le matériau de la couche imprimable, éventuellement le matériau de la couche tampon, dose, énergie, temps d'exposition de la couche implantée au faisceau d'ions.

- Selon un mode de réalisation, la couche sous-jacente est une couche ou un substrat dont le matériau est pris parmi : le silicium, le silicium germanium, le germanium, le quartz. Selon un mode de réalisation, la couche sous-jacente est une couche mince ou une couche active formée d'un ou plusieurs matériaux conducteurs.

- La couche imprimable est formée d'un ou plusieurs matériaux imprimables. Elle est typiquement formée d'une résine imprimable.

- Selon un mode de réalisation, la couche sous-jacente est directement au contact de la couche imprimable.

- Selon un mode de réalisation, la couche sous-jacente est une couche ou un substrat dont le matériau est du SiOCH.

- Selon un mode de réalisation, lors de l'implantation la couche sous-jacente en SiOCH est surmontée d'une couche tampon située entre la couche imprimable et la couche sous-jacente. Selon un mode de réalisation, le procédé comprend une étape de retrait de la couche imprimable et lors de l'étape de retrait, la couche sous-jacente en SiOCH est surmontée de la couche tampon. Ainsi la couche tampon protège le SiOCH lors de l'étape de retrait de la couche imprimable. En effet le SiOCH, surtout lorsqu'il est poreux, peut-être endommagé lors de cette étape. Ce mode de réalisation permet ainsi de conserver un très bon état de surface.

- Selon un mode de réalisation, la couche tampon est en SixNy ou en SixOy, de préférence en SiN ou en SiO2. Selon un mode de réalisation, lors de l'implantation la couche tampon présente une épaisseur supérieure ou égale à 10nm et de préférence supérieure ou égale à 20 nm.

- Selon un mode de réalisation, la couche sous-jacente forme la couche active d'une cellule photovoltaïque.

- Selon un mode de réalisation, la couche sous-jacente est un substrat en saphir et forme avec les motifs ultérieurs un substrat de saphir structuré (PSS).

- Selon un mode de réalisation, l'invention porte sur un procédé de fabrication d'une diode à émission de lumière (LED) comprenant un substrat de saphir structuré (PSS), dans lequel le substrat de saphir structuré (PSS) est obtenu par le procédé du paragraphe précédent.

- Selon un mode de réalisation, l'invention porte sur un procédé de fabrication d'une pluralité de cellules photovoltaïques, comprenant un substrat recouvert de motifs, dans lequel les motifs sont obtenus par le procédé selon l'invention.

Il est précisé que dans le cadre de la présente invention, le terme « sur », « surmonte », « recouvre » ou « sous-jacent » ou leurs équivalents ne signifient pas « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par au moins une autre couche ou au moins un autre élément.

Dans le cadre de la présente invention, l'épaisseur d'une couche est prise selon une direction perpendiculaire aux faces principales du substrat sur lequel repose les différentes couches. Sur les figures, l'épaisseur est prise selon la direction Z.

Dans le cadre de la présente invention, on désigne par motif en trois dimensions (3D) un motif présentant dans une couche donnée, par exemple une résine ou un substrat, un profil analogique avec une variation continue des tangentes de la forme du profil comme dans la figure 11 ou présentant au moins deux niveaux de profondeur au-dessous de la face supérieure de la couche lorsque le motif est en creux ou au moins deux niveaux de hauteur au-dessus d'une face supérieure de la couche lorsque le motif est en saillie. Un motif dit 2D désigne le cas particulier d'un motif n'ayant que deux niveaux de hauteur ou de profondeur comme dans l'exemple de la figure 1.

Un mode de réalisation de la présente invention va maintenant être décrit

Dans une première étape 410 on procède de façon conventionnelle à une opération de nano-impression dans une couche imprimable 110 à l'aide d'un moule. Le moule présente des reliefs aux formes possiblement complexes. La couche imprimable 110 est typiquement formée d'une couche de résine imprimable.

De préférence avant impression la couche imprimable 110 a été déposée sur une couche sous-jacente destinée à être graver 120.

La couche sous-jacente est typiquement un substrat 120 ou une couche mince. Dans la suite de la description, par souci de concision et de clarté, on désigne par « substrat 120 » cette couche sous-jacente à la couche imprimable 110 et dans laquelle les motifs de la résine vont être transférés. Ce terme n'est aucunement limitatif de la nature et de la fonction de cette couche. Les termes « substrat », « couche à graver » et « couche sous-jacente » sont ainsi équivalents.

Lors de l'opération d'impression on ne cherche pas, comme on le fait dans les techniques de l'art antérieur à minimiser l'épaisseur 130 de la couche résiduelle 131. On s'assure au contraire que cette dernière est d'une épaisseur la plus homogène possible sur l'intégralité de la surface considérée.

Dans une deuxième étape 420 on procède à une implantation 421 d'ions d'éléments gazeux dans le but d'obtenir une modification structurelle du matériau constituant la couche à graver 120 à partir de sa surface.

Les ions utilisés sont par exemple pris parmi : l'hydrogène (H), l'argon (Ar), l'azote (N) et l'hélium (He).

L'implantation se fait à travers la couche imprimable 110 préformée par nano-impression. L'implantation se fait donc à différentes profondeurs dans le substrat 120 reproduisant les motifs en relief de la couche imprimable 110 et formant ainsi une zone 122 de matériau modifié.

En effet, si la capacité de pénétration des ions dans le matériau de la couche imprimable 110 et dans celui du substrat 120 sont sensiblement identiques, la profondeur de pénétration des ions, mesurée selon la direction d'implantation et en chaque point de la face la couche imprimable 110 par laquelle pénètre les ions est uniforme. Ainsi, la profondeur de pénétration reproduit les motifs de la couche imprimable 110. L'implantation est ainsi conforme, dans le sens où le profil formé par la frontière entre les zones implantées et les zones non implantées reproduit le profil des motifs imprimés dans la couche imprimable.

Par conséquent, les zones dans le substrat 120 sous les régions où l'épaisseur de résine est la plus faible sont modifiées plus en profondeur que les zones où l'épaisseur de résine imprimable est forte.

Selon un autre mode de réalisation on prévoit que les profondeurs de pénétration des ions dans la couche imprimable et dans le substrat sont différentes. Les motifs reproduits dans le substrat ne sont alors pas conformes à ceux de la résine imprimable. Les motifs implantés dans la couche sous-jacente sont alors des homothéties des formes initiales. De préférence, on aura une profondeur de pénétration plus faible pour le substrat (couche sous-jacente) car habituellement la densité du matériau du substrat est plus élevée que la densité du matériau imprimable, donc la pénétration des ions est rendue plus difficile.

La modification obtenue par l'implantation d'ions consiste, par exemple, à rendre amorphe un matériau initialement cristallin. Le matériau rendu amorphe est typiquement du silicium (Si) cristallin très largement utilisé par l'industrie de la microélectronique. L'implantation est réglée pour que les zones de la couche ou substrat 120 sous les zones où l'épaisseur de résine est la plus importante ne soient pas modifiées.

À l'étape suivante 430 on peut alors procéder au retrait de la couche imprimable 110. La méthode de retrait est adaptée au type de résine utilisée. Il peut s'agir d'une gravure dite « humide » c'est-à-dire qu'elle est effectuée dans une solution liquide adaptée qui dissout la résine sans attaquer les couches sous-jacentes. On peut aussi avoir recours à une gravure dite « sèche » à partir d'un plasma formé dans une enceinte confinée. Ces techniques sont bien connues et communément employées par l'industrie de la microélectronique.

La dernière étape du procédé de l'invention consiste à enlever les zones 122 faites de matériau modifié par l'implantation d'ions dans la couche 120. Cette étape de retrait est uniquement optionnelle. Cette étape de retrait est effectuée sélectivement aux zones non modifiées du substrat 120. Les conditions d'implantation et de gravure sont ainsi réglées de manière à ce que la gravure soit sélective des zones modifiée 122 par implantation vis-à-vis des zones non modifiées qui ne sont pas, ou que bien moins, retirées par gravure.

Par exemple, le retrait de ces zones 122 se fait à l'aide d'une gravure humide en utilisant typiquement du tetramethylammonium hydroxide (TMAH) ou encore de l'acide fluorhydrique (HF) sous atmosphère d'oxygène.

À l'issue de ces étapes le profil imprimé dans la résine est transféré dans la couche sous-jacente 120, typiquement un substrat ou une couche mince fonctionnelle d'un dispositif en cours de fabrication.

On remarquera ici que le procédé de l'invention ne nécessite pas l'enlèvement de la couche résiduelle 131 de résine avec tous les inconvénients mentionnés dans l'état de la technique. Un critère de qualité de cette dernière est son homogénéité en épaisseur (dans le plan X,Y). Or il a été constaté que cette uniformité est d'autant plus facilement obtenue qu'on ne cherche pas à la minimiser. Cette homogénéité d'épaisseur de la couche résiduelle 131 et des reliefs va permettre une reproduction fidèle des motifs imprimés par l'intermédiaire d'une implantation ionique qui se fera alors de manière identique sur toute la surface d'une tranche ou « wafer », l'élément de base à partir duquel les dispositifs microélectronique sont communément produits.

Les explications qui suivent apportent des précisions supplémentaires et optionnelles sur les étapes du procédé de l'invention et propose des exemples particuliers de mise en oeuvre.

Le substrat ou la couche à graver 120 sont typiquement faits de silicium. Plus généralement tous les substrats cristallins incluant ceux en quartz et en saphir sont susceptibles de bénéficier de l'application du procédé de l'invention. Ceux en silicium présentent par ailleurs comme avantage d'être compatibles avec tous les procédés développés pour les micro et nanotechnologies.

Le matériau constituant la couche 110 qui sert de masque temporaire peut être comme on l'a vu une résine utilisée en lithographie ou un polymère inorganique du type de ceux obtenus par les procédés dits « solgel ». Comme discuté dans l'état de la technique la formation des motifs 3D dans la couche 110 utilise traditionnellement la technologie de lithographie par nano impression à partir d'un moule qui contient lui-même les motifs à reproduire. Si le moule est fabriqué dans un matériau non transparent aux longueurs d'ondes de l'ultra-violet (UV), ce qui est le cas d'un moule fait de silicium par exemple, on aura alors recours à un procédé de nano-impression thermique et à l'utilisation d'une résine thermoplastique. L'épaisseur de résine déposée sera déterminée, comme discuté dans le chapitre sur l'état de la technique, par le volume des cavités du moule qu'il faut remplir et en prévoyant que l'épaisseur résiduelle après pressage soit non nulle et au moins égale à une profondeur minimale d'implantation.

Par ailleurs, comme déjà mentionné, on cherche à optimiser le procédé d'impression de telle sorte que l'épaisseur résiduelle soit homogène sur toute la surface imprimée plutôt que de chercher à la minimiser comme c'est le cas pour les procédés de transfert par gravure sèche. Cette phase d'optimisation de l'homogénéité est généralement atteinte lorsque l'épaisseur résiduelle après pressage est plus importante.

Pour le procédé d'impression thermique ce dernier peut être réalisé, par exemple, avec une résine du type PMMA (polyméthacrylate de méthyle), PS (polystyrène), à des pressions de quelques bars à plusieurs dizaines de bars et à des températures de transition vitreuse de la résine (Tg) comprises entre + 10°C et + 100°C. L'étape de démoulage, opération où l'on sépare le moule de la couche de résine, est réalisée à des températures inférieures à ces températures de transition (Tg) de telle sorte que la résine soit alors solide.

Pour l'étape 420 d'implantation on aura classiquement recours à un implanteur dit à « ligne de faisceau ». Cet équipement comprend une source de production d'ions, un accélérateur de particules utilisant les propriétés électrostatiques de l'ion pour l'accélérer et une chambre pour la cible. Les ions sont ainsi accélérés et dirigés vers la cible où se situe le dispositif à implanter. Dans ce cas, la profondeur implantée peut atteindre plusieurs centaines de nanomètres. Par contre, il est difficile d'implanter en surface car il existe une énergie minimale non nulle fournie aux ions qui est de 1keV (kilo électron volt). Cette énergie minimale provoque inévitablement une pénétration des ions implantés dans le substrat. Les ions se trouvent donc à distance de la surface de ce dernier, même si cela reste à faible profondeur. Il existe ainsi une zone entre la surface et cette profondeur dépourvue ou avec un très faible taux d'espèce implantée. Cela ne permet donc pas qu'une modification en surface, de l'ordre de quelques nanomètres seulement, puisse se faire.

La profondeur minimale d'implantation que l'on peut obtenir dans ces conditions est d'environ 30 nm.

Or, dans le cadre de la présente invention on cherche à implanter une zone qui soit enterrée. Ainsi, on n'implante pas les ions depuis la surface de la couche sous-jacente 120. Cela permet de définir une zone, non implantée s'étendant depuis la surface de la couche sous-jacente 120.

Si la profondeur minimale d'implantation est supérieure à l'épaisseur de certaines zones de la couche imprimable, alors la couche sous-jacente ne sera pas modifiée depuis sa surface au droit de ces zones. Plus précisément, une région supérieure de la couche sous-jacente, s'étendant depuis sa surface, ne sera pas modifiée.

L'ajout d'une couche tampon 510, dont un avantage sera mentionné par la suite, doit être contrôlé pour que les ions une fois implantés, ne soient implantée qu'à partir d'une profondeur non nulle. Ainsi on choisira l'épaisseur de la couche résiduelle 131 de manière à ce qu'elle soit moins épaisse que la profondeur minimale de l'implantation.

L'épaisseur de cette couche permet alors d'implanter le substrat 120 en créant à la surface de la couche à graver 120 une couche continue 127 non implantée. Dans ce type de réacteur, l'implantation est réalisée à une profondeur donnée, généralement notée Rp. Autour de cette profondeur Rp, la zone d'implantation s'étend typiquement sur quelques dizaines de nanomètres selon la direction d'implantation. Pour obtenir une modification continue du substrat mais enterrée sous une couche non implantée, il est alors nécessaire d'assurer un recouvrement des profondeurs modifiées du substrat après chaque étape d'implantation.

Un exemple des résultats d'une opération d'implantation effectuée à l'étape 420 est illustré par la **figure 7b.** Cette implantation est appliquée à l'empilement de couches illustré en **figure 7a.**

L'empilement comprend successivement un substrat 120, une couche tampon 510 et une couche imprimable 110. Dans cet exemple la couche tampon 510 est faite de SiARC, un matériau anti réfléchissant couramment utilisé en lithographie. Elle est dans ce cas d'une épaisseur de 100 nm pour une implantation dans le silicium constituant le substrat qui s'étend 520 sur une profondeur de 350 nm.

Comme on le voit sur la figure 7b on procède dans cet exemple à cinq implantations successives d'ions hydrogène (H) avec des énergies entre 5 et 25 keV et une même dose de $10^{15}$ atomes/cm$^2$. Les conditions sont calculées pour qu'il y ait recouvrement des profils d'implantation. Les implantations sont obtenues à des profondeurs et avec des recouvrements comme indiqué dans le tableau 530.

Dans cet exemple, pour obtenir des zones modifiées 122 situées sous une couche 127 non modifiée s'étendant depuis la face supérieure de la couche à graver 120, on voit ainsi que les implantations à 5 et 10 keV doivent être évitées.

L'étape de retrait de la couche imprimable 110 est ensuite réalisée par exemple dans une chambre de gravure en utilisant une chimie à base d'oxygène ou par voie humide en utilisant une chimie couramment utilisée par l'homme du métier employant un mélange dit SPM d'acide sulfurique (H2SO4) combiné au peroxyde d'hydrogène ou eau oxygénée (H2O2). Cette étape est parfaitement connue et maitrisée par l'homme du métier.

On notera que pour accéder aux zones modifiées 122 enterrées sous la couche non modifiée 127, il peut être utile de pratiquer des ouvertures 123. La solution de gravure est introduite par ces ouvertures.

Les conditions de retrait de la couche modifiée doivent être telles que ce procédé ne doit pas ou peu consommer le matériau non modifié c'est-à-dire pas plus de quelques nanomètres par minute. Typiquement, le substrat est fait de silicium et il s'agit de retirer dans les conditions décrites le silicium rendu amorphe par l'implantation sélectivement au silicium cristallin. Comme déjà mentionné, l'utilisation de tetramethyl ammonium hydroxide, amoniac (TMAH) ou d'acide fluorhydrique (HF) sous atmosphère d'oxygène est particulièrement avantageuse. Le silicium cristallin n'est en effet pas ou peu consommé par ce type de nettoyage.

Les paragraphes ci-dessous décrivent un autre avantage directement lié à l'épaisseur résiduelle 131 qui demeure dans le fond des motifs après impression nanométrique.

En effet ce résidu de résine, habituellement perçu comme un inconvénient de la nano-impression, est ici utilisé comme couche de protection protégeant la couche à graver 120 lors de l'implantation. Cette épaisseur résiduelle 131 n'est pas gravée, ou pas entièrement gravée, lors de l'étape d'implantation 421. Au droit des motifs nanoimprimés, la couche à graver 120 n'est ainsi pas à nu lors de l'implantation.

Ce mode de réalisation présente un avantage important. En effet, en l'absence d'un résidu d'épaisseur suffisante, l'implantation recherchée de la couche à graver 120 produit inévitablement un bombardement de la surface de la couche imprimable 110 carbonée. Cette couche de masquage 110 est ainsi pulvérisée en surface. Ce bombardement tend à rayonner des atomes de carbone initialement présents dans la couche imprimable 110. Une partie de ces atomes de carbone est projetée dans la couche à graver 120, là où elle est à nu. Dans le cadre du développement de la présente invention il s'est avéré que ces atomes de carbone pénètrent dans la couche à graver 120 et forment alors dans cette dernière un film de surface enrichi en carbone ce qui peut, en fonction des applications, modifier le comportement de cette couche. Par exemple cette implantation parasite de carbone peut modifier les propriétés d'énergie de surface ou les propriétés optiques de la couche à graver 120.

L'invention, en prévoyant une épaisseur résiduelle 131 qui évite de mettre à nu la couche à graver 120 au droit du motif nano-imprimé de la couche imprimable 110, parvient à protéger la face 128 de la couche à graver 120 de tout apport de carbone. L'épaisseur 130 de l'épaisseur résiduelle 131 est choisie de manière à ce que les atomes de carbone ne la traverse pas. Typiquement cette épaisseur est supérieure à 20 nm et de préférence supérieure à 30nm lors de l'implantation.

L'épaisseur résiduelle 131 recouvrant la couche à graver 120 est retirée, par exemple lors de la gravure de cette dernière.

La **figure 4** composée des figures 4a à 4c, illustre un mode de réalisation particulier de la présente invention. Ce mode de réalisation permet de réaliser des structures 3D enterrées dont les propriétés, par exemple électriques, optiques, magnétiques, mécanique et thermiques, sont modifiées. Cette variante comprend les étapes suivantes:

- Comme illustré par la figure 4a on procède, comme à l'étape 410 précédemment décrite, à une nano-impression de formes complexes dans un matériau imprimable 110. Comme indiqué ci-dessus, de préférence on ne cherche pas à minimiser l'épaisseur 130 de la couche résiduelle 131 afin de s'assurer que cette dernière soit homogène sur l'intégralité de la surface considérée.

- Ensuite, comme illustré sur la figure 4b, on réalise une implantation 421 d'ions, par exemple des ions hydrogène, au travers de la couche imprimable 110 préformée par nano-impression, à différentes profondeurs, dans la couche sous-jacente 120, c'est-à-dire le substrat ou la couche mince à structurer. Les zones dans la couche sous-jacente 120 sous les régions ou l'épaisseur de résine est la plus faible seront modifiées plus en profondeur. Le matériau de la couche sous-jacente 120 sera modifié par implantation, par exemple en le rendant amorphe alors qu'il est initialement cristallin. Les zones du substrat sous les zones où l'épaisseur de résine est la plus importante ne sont pas modifiées par l'implantation. Les implantations sont réglées dans ce cas pour que la zone modifiée par l'implantation la plus proche de l'interface avec l'air c'est-à-dire l'interface substrat/résine ou couche/résine soit enterrée d'une épaisseur prédéterminée 126 de telle sorte qu'elle ne pourra être retirée du substrat ou de la couche par un procédé sec ou humide. Ainsi, au terme de l'implantation, la couche sous-jacente 120 présente une région 127 non modifiée, continue à la surface de la couche sous-jacente 120 et qui s'étend depuis la surface de cette même couche 120 et dans la direction d'implantation.

Plus précisément, la couche à graver 120 présente une zone non modifiée entre chaque zone modifiée 122 par implantation et la face 128 supérieure de cette couche à graver 120. Ainsi aucune zone modifiée 122 par implantation ne s'étend depuis la face 128 supérieure de cette couche à graver 120. La face 128 supérieure de cette couche à graver 120 est la face qui est tournée au regard de la couche imprimable et au travers de laquelle pénètrent les ions lors de l'implantation 421.

Cette zone 127 est donc continue selon l'épaisseur de l'empilement, soit selon la direction z du repère illustré en figure 4a. Cette zone 127 non modifiée s'étend ,dans le cadre de l'invention, sur toute la surface de la couche à graver 120.

L'épaisseur 126 de la zone 127 non modifiée continue n'est pas nécessairement constante sur toute la surface de la couche à graver 120. Sur l'exemple illustré en figure 4b cette épaisseur est constante.

De préférence cette épaisseur 126 est supérieure ou égale à 10nm et de préférence supérieure ou égale à 20nm, de préférence supérieure ou égale à 30nm et de préférence supérieure ou égale à 40nm.

Ainsi les zones modifiées 122 sont toutes situées à distance de la face 128 supérieure de la couche à graver 120.

Cette couche non modifiée 127 permet d'encapsuler les motifs formés par l'implantation 421.

Dans le cadre de l'invention, la profondeur minimale d'implantation est supérieure à l'épaisseur de la couche résiduelle 131.

- Comme illustré sur la figure 4c on procède ensuite au retrait du matériau préalablement nano-imprimé 110 avec des procédés secs et/ou humides, comme déjà décrit, sans affecter la zone modifiée qui est enterrée.

On obtient ainsi des zones modifiées 122 encapsulées dans le matériau non modifié de la couche sous-jacente 120.

Selon un mode de réalisation les zones modifiées 122 sont ultérieurement retirées sélectivement par rapport au matériau non modifié. Pour cela on réalise des ouvertures 123 pour accéder à ces zones, comme illustré en figure 4c.

Dans ce cas les motifs formés par les zones non modifiées sont alors entourés, au moins partiellement, de vide ou de gaz. Le gaz peut être de l'air ambiant. Il peut aussi s'agir d'un gaz injecté dans la cavité formée par le retrait des zones modifiées. En effet, du gaz peut être injecté par l'entrée ayant servi à la gravure des zones modifiées. Les motifs formés par les zones non modifiées présentent alors au moins l'une de leurs propriétés optiques, électriques, magnétiques, thermiques ou mécaniques qui est différente de celle du gaz qui les environne.

Dans le cas où l'on injecte un ou plusieurs gaz dans la ou les cavités, il faut à l'issue de l'injection fermer les ouvertures 123 ayant servi à la gravure des zones modifiées et à l'injection du gaz. Par exemple on pourra déposer une résine à la tournette (par spin coating) qui vient alors boucher les ouvertures 123. Cette résine est de préférence exposée à une source de lumière pour la stabiliser à l'endroit de l'ouverture 123 et le reste de la résine non exposée est retiré par un traitement bien connu de l'homme du métier. On forme ainsi un bouchon à l'endroit des ouvertures 123.

Selon un autre mode de réalisation les zones modifiées 122 sont conservées. Elles ne sont pas retirées sélectivement par rapport au matériau non modifié. Dans ce cas au moins l'une de leurs propriétés optiques, électriques, magnétiques, thermiques ou mécaniques est différente de celle des motifs formés par une zone non modifiée.

Cette solution pour encapsuler et protéger des motifs est particulièrement avantageuse. En effet elle est précise, permet un très bon contrôle dimensionnel des motifs. Par ailleurs, elle est plus rapide, moins complexe et moins couteuse qu'une solution consistant à déposer sur les zones préalablement implantées ou sur les zones préalablement implantées et gravées une couche d'encapsulation.

La **figure 5** composée des figures 5a à 5e décrit une variante de mise en oeuvre du procédé dans laquelle, après l'étape, où l'on vient former les motifs 3D dans la couche imprimable 110, et avant l'étape d'implantation 421, on insère une étape supplémentaire au cours de laquelle, comme montré sur la figure 5b, on effectue un dépôt d'une couche de protection 115 recouvrant les motifs antérieurs formés dans la couche imprimable 110 et protégeant ces motifs lors de l'implantation 421. Cette couche de protection 115 est avantageusement une couche de carbone 115. L'épaisseur déposée est de quelques nanomètres. Typiquement, de 1 à 5 nanomètres de carbone sont déposés. Cette opération peut être réalisée dans une chambre de dépôt ou de gravure dans laquelle on crée un plasma par exemple à base de méthane (CH4). La couche de carbone 115 peut s'avérer nécessaire pour protéger la surface du matériau imprimé par nano impression, avantageusement de la résine, et ainsi limiter la consommation de cette dernière lors de l'étape d'implantation 421 qui suit. Dans le cas de l'utilisation d'une chambre de gravure pour cette opération on peut avoir recours, par exemple, à un réacteur à couplage capacitif (CCP) ou inductif (ICP). Ce type de dépôt bien connu de l'homme du métier peut être obtenu d'une façon générale en utilisant des gaz de type hydrocarbure (CxHy) ou fluorure de carbone (CxFy).

Le retrait de la couche de carbone 115 peut par exemple être effectué par plasma à base d'Oxygène.

Comme indiqué ci-dessus l'invention est particulièrement avantageuse dans le cas où la couche sous-jacente 120 est en silicium ou dans l'un des matériaux suivants : le verre, le silicium germanium, le germanium, le nitrure de silicium, le saphir, le quartz.

Selon encore un autre mode de réalisation la couche à graver est en oxyde de silicium carboné et hydrogéné (SiOCH). Il peut s'agir de SiOCH poreux ou dense. Ce matériau présente pour avantage d'avoir une très faible permittivité, en particulier lorsqu'il est poreux.

Tous les modes de réalisation décrits ci-dessus sont applicables au SiOCH. Les étapes principales d'un mode de réalisation particulièrement avantageux vont être décrites ci-dessous en référence aux figures 6a à 6d.

1. 410- Empilement et lithographie (figure 6a): Une couche de résine formant la couche imprimable 110 est déposée sur une couche sous-jacente 120 de SiOCH qui peut elle-même reposer sur un substrat 121, par exemple en silicium. Entre la couche imprimable 110 et la couche 120 de SiOCH on forme une couche tampon 510, par exemple un oxyde (SiO2) ou plus généralement SixOy ou un nitrure (SiN) ou plus généralement SixNy. Cette couche tampon 510 sera utilisée pour faciliter la lithographie comme cela sera explicité ci-dessous. Elle fait également office de couche tampon pour protéger le SiOCH lors de l'implantation, ce matériau étant de faible densité il est facilement pulvérisé pendant l'implantation.

A partir de cet empilement on effectue une étape de lithographie par nano-impression (NIL). Après pressage du moule il subsiste dans le fond des motifs un résidu de résine 131 présentant une épaisseur 130. Par ailleurs, comme cela a été décrit ci-dessus, l'épaisseur résiduelle 131 forme une couche permettant de stopper les atomes de carbone arrachés à la surface de la couche de résine 110 et qui ont tendance à pénétrer dans la couche sous-jacente 120 de SiOCH.

2. 420- Implantation (figure 6b): L'implantation 421 est réalisée à travers la couche imprimable 110 et donc, au droit des motifs, à travers l'épaisseur résiduelle 131 et la couche tampon 510. L'implantation 421 peut être réalisée dans un équipement d'implantation ionique à faisceau d'ions ou à immersion plasma. L'énergie et la dose d'implantation sont définies en fonction du profil et de la profondeur maximale souhaitée pour l'implantation et de la profondeur minimale de la zone 127 continue non modifiée. L'épaisseur de cette zone 127 est référencée 126. Des simulations sur appliquette Crystal TRansport of Ions in Mater (C-trim) permettent de prédire la profondeur d'implantation dans les matériaux.

L'implantation ionique engendre des modifications dans le matériau, notamment la rupture de certaines liaisons. Sous l'effet de l'implantation, le SiOCH perd ses groupements méthyle et tend vers une structure proche de ou semblable à celle d'un $SiO_2$. Ceci permet de créer une forte sélectivité lors de la gravure humide.

Dans le cadre de la présente invention il a été remarqué que, quelle que soit l'espèce de l'ion implanté, une pulvérisation du SiOCH a lieu. L'intégration de la couche tampon 510 citée précédemment s'avère alors particulièrement avantageuse.

Dans le cadre du développement de la présente invention, l'Hydrogène s'est avéré particulièrement avantageux. L'hydrogène permet en effet d'avoir une sélectivité très forte quand d'autres espèces telles que l'Argon manifestent une résistance « infinie » à la gravure humide au HF.

3. 430- Retrait de la couche de masquage (figure 6c): Le retrait de la couche imprimable 110 en résine peut se faire par voie humide ou sèche. Lors de cette étape la couche tampon 510 protège avantageusement la face supérieure 128 du SiOCH. Cette face 128 n'est donc pas altérée par apport de carbone provenant de la couche imprimable 110.

4. Gravure du SiOCH modifié (figure 6d) (étape optionnelle): Cette étape de gravure est optionnelle. En effet on peut souhaiter conserver le SiOCH modifié. Si l'on souhaite le retirer, la gravure est de préférence effectuée avec une solution d'HF diluée à 1%. Comme expliqué précédemment l'implantation génère des modifications dans le SiOCH qui se traduisent par l'hydrophilisation du matériau, la rupture des groupements méthyle et enfin la formation des liaisons Si-O. Ceci permet d'avoir une sélectivité infinie par rapport à la zone non modifiée à hauteur d'un temps de gravure inférieur à 240 secondes.

Cette étape permet également le retrait de la couche tampon 510, par exemple en SiN ou $SiO_2$.

La technique décrite ci-dessus pour texturer du SiOCH présente plusieurs avantages :

- Le masque formé par la couche imprimable 110 n'est pas métallique mais organique ce qui confère de nombreux avantages en termes de procédé.
- La lithographie par nano-impression utilisée pour créer le motif est peu couteuse et précise. Par ailleurs le résidu de résine dans le fond du motif peut faire office de couche de protection pour protéger la couche de SiOCH contre l'apport non souhaité de carbone lors de l'implantation comme cela a été décrit ci-dessus. Par ailleurs, elle protège le SiOCH lors du retrait de la résine.
- La gravure se fait par voie humide ce qui permet de conserver un contrôle dimensionnel et un état de surface meilleur qu'avec des gravures sèches.

Selon un mode de réalisation alternatif, l'enlèvement de la couche de masquage 110 en résine peut être fait lors de l'étape de gravure humide par solution HF, en particulier si l'on utilise une résine à base de Silicium comme l'Hydrogène silsesquioxane (HSQ).

L'invention n'est pas limitée aux modes de réalisations précédemment décrits et s'étend à tous les modes de réalisation couverts par les revendications.

## Revendications

**1.** Procédé de réalisation de motifs ultérieurs dans une couche sous-jacente (120), le procédé comprenant au moins une étape de réalisation de motifs antérieurs dans une couche imprimable (110) surmontant la couche sous-jacente (120), dans lequel la réalisation des motifs antérieurs comprend une impression nanométrique de la couche imprimable (110) et laisse en place dans le fond des motifs des épaisseurs résiduelles (131) de couche imprimable (110), la couche imprimable (110) formant alors une couche continue recouvrant la couche sous-jacente (120), le procédé comprenant l'étape suivante:

au moins une étape de modification de la couche sous-jacente (120) par implantation (421) d'ions au sein de la couche sous-jacente (120), l'implantation (421) étant réalisée au travers de la couche imprimable (110) comprenant les motifs antérieurs et lesdites épaisseurs résiduelles (131), les paramètres de l'implantation (421) comprennent notamment une direction d'implantation (421) et dans lequel la direction d'implantation (421) est perpendiculaire à un plan principal dans lequel s'étend la couche sous-jacente (120), les paramètres de l'implantation (421) étant choisis de manière à former dans la couche sous-jacente (120) des zones modifiées (122) par l'implantation (421) et des zones non implantées, les zones non implantées définissant les motifs ultérieurs et présentant une géométrie qui est fonction des motifs antérieurs ; dans lequel l'étape de réalisation de motifs antérieurs est réalisée de manière à ce que pour chacun des motifs antérieurs l'épaisseur résiduelle (131) de la couche imprimable (110) soit inférieure à la profondeur minimale d'implantation (421) des ions implantés lors de ladite implantation, la profondeur minimale étant prise selon la direction d'implantation (421) et à partir de la surface de la couche imprimable (110) et dans lequel l'implantation d'ions (421) est réalisée de manière à ce que la couche sous-jacente (120) présente une zone (127) non modifiée continue située entre les zones modifiées (122) et une face (128) de la couche sous-jacente (120) par laquelle les ions pénètrent lors de l'implantation (421), la zone (127) non modifiée s'étendant sur toute la surface de la couche sous-jacente (120), de manière à ce que toutes les zones modifiées (122) par l'implantation soient protégées par la zone (127) non modifiée, ces zones modifiées (122) par l'implantation formant ainsi des zones enterrées ou encapsulées dans le matériau de la couche adjacente (120).

2. Procédé selon la revendication précédente comprenant, après l'étape de modification, au moins une étape de retrait des zones modifiées (122) effectuée de manière sélective par rapport aux zones non modifiées, de manière à laisser en place les zones non modifiées.

3. Procédé selon la revendication précédente dans lequel l'étape de retrait comprend une étape de gravure des zones modifiées (122) sélectivement aux zones non modifiées, l'étape de gravure étant une gravure par voie humide ou par voie sèche.

4. Procédé selon l'une quelconque des trois revendications précédentes dans lequel ladite gravure des zones modifiées (122) forme au moins une cavité, dans lequel on introduit au moins un gaz dans ladite cavité, et dans lequel on forme ensuite un bouchon pour obturer une ouverture (123) par laquelle ledit au moins un gaz a été introduit dans la cavité.

5. Procédé selon la revendication 1 dans lequel, après l'étape de modification, on conserve au moins une partie et de préférence toutes les zones modifiées (122) et les zone non modifiées.

6. Procédé selon la revendication précédente dans lequel les zones modifiées (122) présentent des propriétés différentes de celle des zones non modifiées, les propriétés étant prises parmi des propriétés : électriques, magnétiques, thermiques.

7. Procédé selon la revendication précédente dans lequel les zones modifiées (122) présentent des propriétés optiques différentes de celle des zones non modifiées.

8. Procédé selon l'une quelconque des revendications précédentes comprenant, entre l'étape de réalisation des motifs antérieurs et l'étape d'implantation (421), une étape de dépôt d'une couche de protection recouvrant les motifs antérieurs.

9. Procédé selon la revendication précédente dans lequel la couche de protection est une couche de carbone déposée à partir d'un plasma.

10. Procédé selon l'une quelconque des revendications précédentes dans lequel la couche sous-jacente (120) est une couche ou un substrat dont le matériau est du SiOCH.

11. Procédé selon la revendication précédente comprenant une étape de retrait de la couche imprimable (110) et dans lequel lors de l'étape de retrait, la couche sous-jacente (120) en SiOCH est surmontée d'une couche tampon (510) située entre la couche imprimable (110) et la couche sous-jacente (120).

12. Procédé selon la revendication précédente dans lequel la couche tampon (510) est en SixNy ou en SixOy, de préférence en SiN ou en SiO2.

13. Procédé selon l'une quelconque des revendications précédentes dans lequel la couche sous-jacente (120) forme la couche active d'une cellule photovoltaïque.

14. Procédé selon l'une quelconque des revendications 1 à 9 dans lequel la couche sous-jacente (120) est un substrat en saphir et forme avec les motifs ultérieurs un substrat de saphir structuré (PSS).

15. Procédé de fabrication d'une diode à émission de lumière (LED) comprenant un substrat de saphir structuré (PSS), dans lequel le substrat de saphir structuré (PSS) est obtenu par le procédé de la revendication précédente.

**Patentansprüche**

1. Verfahren zur Erzeugung von nachträglichen Mustern in einer darunter liegenden Schicht (120), wobei das Verfahren mindestens einen Schritt der Erzeugung von älteren Mustern in einer bedruckbaren Schicht (110) über der darunter liegenden Schicht (120) umfasst, wobei die Erzeugung der älteren Muster ein Bedrucken der bedruckbaren Schicht (110) im Nanometerbereich umfasst und auf dem Boden der Muster Restdicken (131) bedruckbarer Schicht (110) belässt, wobei die bedruckbare Schicht (110) somit eine kontinuierliche Schicht bildet, die die darunter liegende Schicht (120) bedeckt, wobei das Verfahren den folgenden Schritt umfasst:

mindestens einen Änderungsschritt der darunter liegenden Schicht (120) durch Ionenimplantation (421) innerhalb der darunter liegende Schicht (120), wobei die Implantation (421) durch die bedruckbare Schicht (110) hindurch durchgeführt wird, die die älteren Muster und die Restdicken (131) umfasst, wobei die Parameter der Implantation (421) insbesondere eine Implantationsrichtung (421) umfassen und wobei die Implantationsrichtung (421) senkrecht zu einer Hauptebene ist, in der sich die darunter liegende Schicht (120) erstreckt, wobei die Parameter der Implantation (421) derart ausgewählt sind, dass in der darunter liegenden Schicht (120) durch die Implantation (421) veränderte Zonen (122) und nicht implantierte Zonen gebildet werden, wobei die nicht implantierten Zonen die nachträglichen Muster definieren und eine Geometrie aufweisen, die von den älteren Mustern abhängt;
wobei der Schritt der Erzeugung älterer Muster derart durchgeführt wird, dass für jedes der älteren Muster die Restdicke (131) der bedruckbaren Schicht (110) kleiner als die minimale Implantationstiefe (421) der bei der Implantation implantierten Ionen ist,
wobei die minimale Tiefe gemäß der Implantationsrichtung (421) und ab der Oberfläche der bedruckbaren Schicht (110) herangezogen wird, und
wobei die Ionenimplantation (421) derart durchgeführt wird, dass die darunter liegende Schicht (120) eine kontinuierliche nicht veränderte Zone (127) aufweist, die sich zwischen den veränderten Zonen (122) und einer Fläche (128) der darunter liegenden Schicht (120) befindet, durch die die Ionen bei der Implantation (421) eindringen, wobei sich die nicht veränderte Zone (127) über die gesamte Oberfläche der darunter liegenden Schicht (120) derart erstreckt, dass alle durch die Implantation veränderten Zonen (122) von der nicht veränderten Zone (127) geschützt werden, wobei diese durch die Implantation veränderten Zonen (122) somit in das Material der benachbarten Schicht (120) eingebettete oder eingekapselte Zonen bilden.

2. Verfahren nach vorangehendem Anspruch, umfassend, nach dem Änderungsschritt, mindestens einen Schritt des Entfernens der veränderten Zonen (122), der selektiv im Verhältnis zu den nicht veränderten Zonen durchgeführt wird, so dass die nicht veränderten Zonen verbleiben.

3. Verfahren nach vorangehendem Anspruch, wobei der Schritt des Entfernens einen Gravurschritt der veränderten Zonen (122) selektiv zu den nicht veränderten Zonen umfasst, wobei der Gravurschritt eine Gravur auf feuchtem Weg oder auf trockenem Weg ist.

4. Verfahren nach einem der drei vorangehenden Ansprüche, wobei die Gravur der veränderten Zonen (122) mindestens eine Kavität bildet, wobei mindestens ein Gas in die Kavität eingeleitet wird, und wobei dann ein Stopfen gebildet wird, um eine Öffnung (123) zu verschließen, durch die das mindestens eine Gas in die Kavität eingeleitet wurde.

5. Verfahren nach Anspruch 1, wobei nach dem Änderungsschritt mindestens ein Teil und vorzugsweise alle veränderten Zonen (122) und die nicht veränderten Zonen behalten werden.

6. Verfahren nach vorangehendem Anspruch, wobei die veränderten Zonen (122) Eigenschaften aufweisen, die von der der nicht veränderten Zonen unterschiedlich sind, wobei die Eigenschaften aus den Eigenschaften elektrisch, magnetisch, thermisch herangezogen sind.

7. Verfahren nach vorangehendem Anspruch, wobei die veränderten Zonen (122) optische Eigenschaften aufweisen, die von der der nicht veränderten Zonen unterschiedlich sind.

8. Verfahren nach einem der vorangehenden Ansprüche, umfassend zwischen dem Schritt der Erzeugung der älteren Muster und dem Schritt der Implantation (421) einen Schritt des Aufbringens einer Schutzschicht, die die älteren Muster bedeckt.

9. Verfahren nach vorangehendem Anspruch, wobei die Schutzschicht eine ausgehend von einem Plasma aufgebrachte Kohlenstoffschicht ist.

10. Verfahren nach einem der vorangehenden Ansprüche, wobei die darunter liegende Schicht (120) eine Schicht oder ein Substrat ist, deren/dessen Material SiOCH ist.

11. Verfahren nach vorangehendem Anspruch, umfassend einen Schritt des Entfernens der bedruckbaren Schicht (110) und wobei, beim Schritt des Entfernens, die darunter liegende Schicht (120) aus Si-

OCH mit einer Pufferschicht (510) überlagert wird, die sich zwischen der bedruckbaren Schicht (110) und der darunter liegenden Schicht (120) befindet.

**12.** Verfahren nach vorangehendem Anspruch, wobei die Pufferschicht (510) aus SixNy oder aus SixOy, vorzugsweise aus SiN oder aus Si02, ist.

**13.** Verfahren nach einem der vorangehenden Ansprüche, wobei die darunter liegende Schicht (120) die aktive Schicht einer Photovoltaikzelle bildet.

**14.** Verfahren nach einem der Ansprüche 1 bis 9, wobei die darunter liegende Schicht (120) ein Substrat aus Saphir ist und mit den nachträglichen Mustern ein strukturiertes Saphirsubstrat (PSS) bildet.

**15.** Verfahren zur Herstellung einer Lichtemissionsdiode (LED), umfassend ein strukturiertes Saphirsubstrat (PSS), wobei das strukturierte Saphirsubstrat (PSS) durch das Verfahren des vorangehenden Anspruchs gebildet ist.

**Claims**

**1.** A method for making subsequent patterns in an underlayer (120), the method comprising at least one step of making prior patterns in a printable layer (110) topped with the underlayer (120), wherein making of the prior patterns comprises a nanometric printing of the printable layer (110) and leaves residual thicknesses (131) of printable layer (110) in place in the bottom of the patterns, the printable layer (110) then forming a continuous layer covering the underlayer (120), the method comprising the following step:

at least one step of modifying the underlayer (120) by ion implantation (421) within the underlayer (120), the implantation (421) being carried out throughout the printable layer (110) comprising the prior patterns and said residual thicknesses (131), the implantation parameters (421) comprise in particular a direction of implantation (421) and wherein the direction of implantation (421) is perpendicular to a main plane in which the underlayer (120) extends, the implantation parameters (421) being selected so as to form in the underlayer (120) areas (122) modified by the implantation (421) and non-implanted areas, the non-implanted areas defining the subsequent patterns and having a geometry that depends on the prior patterns;
wherein the step of making prior patterns is carried out so that for each of the prior patterns the residual thickness (131) of the printable layer (110) is smaller than the minimum depth of implantation (421) of the ions implanted during said implantation, the minimum depth being considered according to the direction of implantation (421) and from the surface of the printable layer (110) and
wherein the ion implantation (421) is carried out so that the underlayer (120) has a continuous non-modified area (127) located between the modified areas (122) and a face (128) of the underlayer (120) through which the ions penetrate during the implantation (421), the non-modified area (127) extending over the entire surface of the underlayer (120), so that all areas (122) modified by the implantation are protected by the non-modified area (127), these areas (122) modified by the implantation thereby forming areas buried or encapsulated in the material of the adjacent layer (120).

**2.** The method according to the preceding claim, comprising, after the modification step, at least one step of removing the modified areas (122) performed selectively with regards to the non-modified areas, so as to leave the non-modified areas in place.

**3.** The method according to the preceding claim, wherein the removal step comprises a step of etching the modified areas (122) selectively with regards to the non-modified areas, the etching step consisting of a wet or dry etching.

**4.** The method according to any one of the three preceding claims, wherein said etching of the modified areas (122) forms at least one cavity, wherein at least one gas is introduced into said cavity, and wherein a plug is formed afterwards to seal an opening (123) through which said at least one gas has been introduced into the cavity.

**5.** The method according to claim 1, wherein, after the modification step, at least part, and preferably all, of the modified areas (122) and the non-modified areas are preserved.

**6.** The method according to the preceding claim, wherein the modified areas (122) have properties different from those of the non-modified areas, the properties being selected amongst electrical, magnetic, thermal properties.

**7.** The method according to the preceding claim, wherein the modified areas (122) have optical properties different from those of the non-modified areas.

**8.** The method according to any one of the preceding claims, comprising, between the step of making the prior patterns and the implantation step (421), a step of depositing a protective layer covering the prior patterns.

9. The method according to the preceding claim, wherein the protective layer is a carbon layer deposited from a plasma.

10. The method according to any one of the preceding claims, wherein the underlayer (120) is a layer or a substrate whose material consists of SiOCH.

11. The method according to the preceding claim, comprising a step of removing the printable layer (110) and wherein during the removal step, the SiOCH underlayer (120) is topped with a buffer layer (510) located between the printable layer (110) and the underlayer (120).

12. The method according to the preceding claim, wherein the buffer layer (510) is made of SixNy or SixOy, preferably SiN or SiO2.

13. The method according to any one of the preceding claims, wherein the underlayer (120) forms the active layer of a photovoltaic cell.

14. The method according to any one of claims 1 to 9, wherein the underlayer (120) is a sapphire substrate and forms with the subsequent patterns a patterned sapphire substrate (PSS).

15. A method for manufacturing a light-emitting diode (LED) comprising a patterned sapphire substrate (PSS), wherein the patterned sapphire substrate (PSS) is obtained by the method of the preceding claim.

# Art Antérieur

105

100

112

110

120

## Figure 1a

## Figure 1b

130

120

131

## Figure 1c

210

112

110

120

Z
Y
X

## Figure 2

# Art Antérieur

130
131'
131"
110
120

## Figure 3a

320

## Figure 3b

310

## Figure 3c

## Figure 3d

Figure 4a

Figure 4b

Figure 4c

410

130

131    131

110

120

## Figure 5a

130

131    131

115
110

120

## Figure 5b

421

115

110

131    127

126

420

128

120

122

## Figure 5c

127

126

430

120

123
122

## Figure 5d

Figure 6a

Figure 6b

Figure 6c

Figure 6d

Figure 7a

Figure 7b

EP 3 238 232 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2014175051 A1
- FR 2977071 A1
- US 2013284697 A1
- US 2011097827 A1

**Littérature non-brevet citée dans la description**

- **ZHANNA SMAGINA et al.** Nucleation and epitaxial growth of Ge nanoislands on Si surface prepatterned by ion irradiation. *Physica Status Solidi. A: Applications and Materials Science,* 2013, vol. 210 (8), 1522-1524
- **WEI ZHOU et al.** Fabrication of bridged-grain polycrystalline silicon thin film transistors by nanoimprint lithography. *Thin Solid Films,* 2013, vol. 534, 636-639
- **SCHMIDT CHRISTOPH et al.** Artificial sub-$\mu$m magnetic patterning by He+ ion bombardment through a mask fabricated by Ultraviolet NanoImprint Lithography (UV-NIL). *Nuclear Instruments & Methods in Physics Research. Section B: Beam Interactions with Materials and Atoms,* 2014, vol. 322, 59-62